# EUROPÄISCHE PATENTSCHRIFT

(11) **EP 0 572 706 B1**
(45) Veröffentlichungstag und Bekanntmachung des Hinweises auf die Patenterteilung: **11.12.1996**
(21) Anmeldenummer: 92109582.4
(22) Anmeldetag: 05.06.1992
(51) Int. Cl.: H03K 17/06

(54) **Ansteuerschaltung für einen Leistungs-FET mit sourceseitiger Last**
Control circuit for a power-FET with a load connected to its source
Circuit de commande pour un transistor à effet de champ de puissance dont le source et connectée à une charge

(43) Veröffentlichungstag der Anmeldung: 08.12.1993
(73) Patentinhaber: SIEMENS AKTIENGESELLSCHAFT, 80333 München (DE)
(72) Erfinder: Tihanyi, Jenö, Dr.-Ing., W-8000 München 21 (DE)

(56) Entgegenhaltungen:
- EP-A- 0 236 967
- EP-A- 0 337 857
- EP-A- 0 369 048
- EP-A- 0 405 407
- US-A- 4 970 420
- SIEMENS FORSCHUNGS- UND ENTWICKLUNGSBERICHTE Bd. 17, Nr. 1, 1988, Berlin, DE, SS. 35-42, XP106185, TIHANYI: 'Smart SIPMOS Technology' *
- EDN ELECTRICAL DESIGN NEWS, Bd. 36, Nr. 11, 23. Mai 1991, Newton, Massachusetts, US, S. 165, XP231144; GRADY: 'Disconnect switch saves battery'

## Beschreibung

Die Erfindung bezieht sich auf eine Schaltungsanordnung zum Ansteuern eines Leistungs-FET, dem sourceseitig eine Last in Reihe geschaltet ist, mit den Merkmalen:
a) Die Gate-Elektrode des Leistungs-FET ist über eine erste Diode und einen Kondensator mit einem ersten Eingangsanschluß verbunden,
b) zwischen erster Diode und Kondensator ist eine zweite Diode angeschlossen, die über die Drain-Source-Strecke eines zweiten FET mit dem Drain-Anschluß des Leistungs-FET verbunden ist,
c) der zweite FET ist vom dem Leistungs-FET entgegengesetzen Kanaltyp,
d) zwischen Gate- und Source-Anschluß des zweiten FET ist ein Widerstand angeschlossen,
e) der Gate-Anschluß des zweiten FET ist mit einem steuerbaren Schalter verbunden,
f) die Gate-Source-Kapazität des Leistungs-FET ist über die Drain-Source-Strecke eines dritten FET entladbar.

Eine solche Schaltungsanordnung ist z.B. in der europäischen Patentanmeldung 0 236 967 beschrieben worden. Sie arbeitet nach dem Prinzip der bekannten Spannungsverdopplerschaltung. Hiermit ist es möglich, einen Leistungs-FET mit sourceseitiger Last auch dann voll leitend zu steuern, wenn die Spannung am Steuereingang kleiner als die Drainspannung ist. Bei der beschriebenen Schaltung liegt der Drain-Anschluß des zweiten und der Source-Anschluß des dritten FET an Masse. Die Last liegt ebenfalls auf Massepotential. In einer komplexen Anordnung, z.B. einem Kraftfahrzeug, können nun zwischen dem Massepotential der Ansteuerschaltung, zu der die erwähnte Schaltungsanordnung gehört und demjenigen Massepotential, an der die Last liegt, erhebliche Unterschiede auftreten.

Die Funktionsfähigkeit der beschriebenen Schaltungsanordnung ist daher im Betrieb nicht immer gewährleistet.

Der Erfindung liegt die Aufgabe zugrunde, eine Schaltungsanordnung der eingangs erwähnten Art so weiterzubilden, daß ihre Funktionsfähigkeit auch dann gewährleistet ist, wenn die erwähnten Massepotentiale voneinander abweichen.

Diese Aufgabe wird gelöst durch die folgenden Merkmale:
g) Der dritte FET ist eine Depletion-FET,
h) der Gate-Anschluß des Depletion-FET ist mit dem steuerbaren Schalter verbunden,
i) die Drain-Source-Strecke des Depletion-FET ist zwischen den Gate-Anschluß und den Source-Anschluß des Leistungs-FET geschaltet,
k) der steuerbare Schalter (12) ist mit einem zweiten Eingangsanschluß verbunden,
1) an den zweiten Eingangsanschluß wird eine Spannung angelegt, die kleiner als die Versorgungsspannung ist.

Weiterbildungen der Erfindung sind Gegenstand der Unteransprüche.

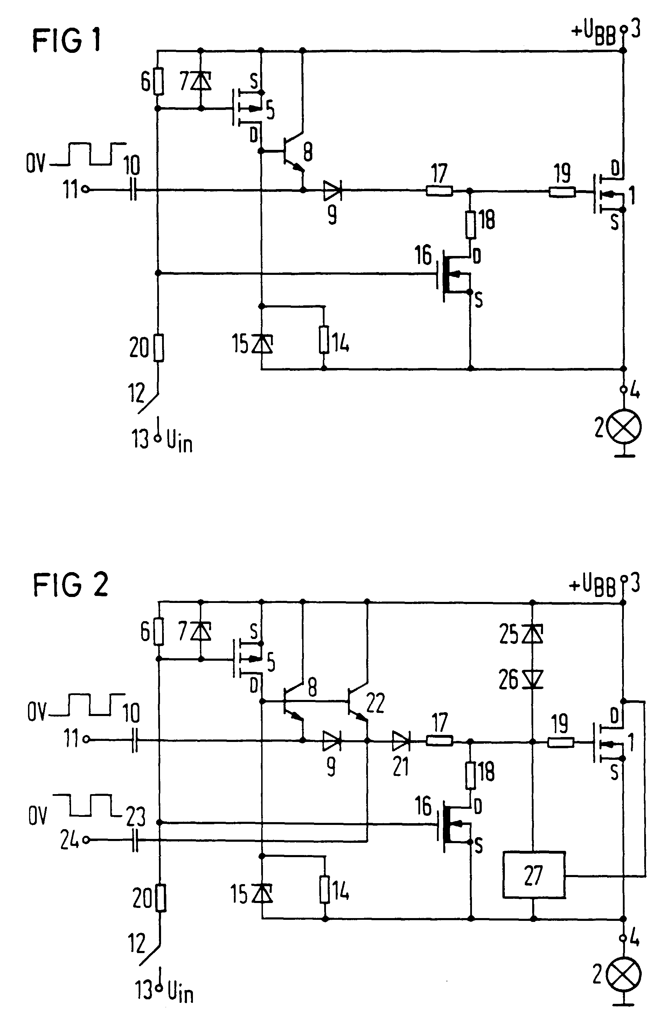

Die Erfindung wird anhand einiger Ausführungsbeispiele in Verbindung mit den Figuren 1 und 2 näher erläutert. Es zeigen:
- Figur 1: die Grundschaltung der Erfindung und
- Figur 2: eine weitere, auf der Schaltung nach Figur 1 basierende Schaltung mit mehreren funktionell voneinander unabhängigen Weiterbildungen.

Die Schaltungsanordnung nach Figur 1 enthält einen Leistungs-FET 1, dessen Drain-Anschluß D über einen Anschluß 3 an einer Versorgungsspannung +U_{BB} liegt. Sein Source-Anschluß ist über einen Anschluß 4 mit einer Last 2 verbunden. Diese Last liegt einseitig an Masse (Lastmasse). Zwischen dem Drain-Anschluß und dem Source-Anschluß des Leistungs-FET 1 liegt die Reihenschaltung aus einem zweiten FET 5 und einem Widerstand 14. Der FET 5 ist vom dem Leistungs-FET entgegengesetzten Kanaltyp. Sein Source-Anschluß ist mit dem Drain-Anschluß des Leistungs-FET 1 verbunden, sein Drain-Anschluß mit dem Widerstand 14. Zwischen den Gate-Anschluß des zweiten FET 5 und seinem Source-Anschluß ist ein Widerstand 6 angeschlossen.

Der Gate-Anschluß des Leistungs-FET 1 ist über Widerstände 17, 19 und eine erste Diode 9 mit einem Anschluß eines Kondensator 10 verbunden, sein anderer Anschluß mit einem ersten Eingangsanschluß 11. Mit dem Verbindungspunkt zwischen Kondensator 10 und erster Diode 9 ist der Emitteranschluß eines npn-Bipolartransistors 8 verbunden. Sein Basisanschluß ist mit dem Drain-Anschluß des zweiten FET 5 verbunden, sein Kollektoranschluß mit dessen Source-Anschluß. Zwischen dem Gate-Anschluß des Leistungs-FET 1 und seinem Source-Anschluß liegt über einen Widerstand 18 die Drain-Source-Strecke eines dritten FET 16, der als Depletion-FET ausgebildet ist. Sein Source-Anschluß ist mit dem Source-Anschluß des Leistungs-FET 1 verbunden. Der Gate-Anschluß von 16 liegt einerseits über einen Widerstand 20 und einen steuerbaren Schalter 12 an einem zweiten Eingangsanschluß 13 und andererseits am Gate-Anschluß des zweiten FET 5.

Wird der steuerbare Schalter 12 eingeschaltet, so wird eine Eingangsspannung Uᵢₙ an den Gate-Anschluß des FET 5 gelegt, die kleiner ist als die Versorgungsspannung +U_{BB}.

Damit fließt ein Strom vom Anschluß 3 über den Widerstand 6, den Widerstand 20, den steuerbaren Schalter 12 zum Anschluß 13. Die Widerstände 6 und 20 sind derart bemessen, daß der FET 5 leitend gesteuert und der Depletion-FET 16 gesperrt wird. Damit fließt ein Strom über die Drain-Source-Strecke des FET 5 einerseits durch den Widerstand 14 und andererseits in den Basisanschluß des Bipolartransistors 8. Der Bipolartransistor wird damit leitend gesteuert und ein Strom fließt über die Diode 9, die Widerstände 17 und 19 zum Gate-Anschluß des Leistungs-FET 1 und lädt dessen Gate-Source-Kapazität auf. Dieser beginnt damit zu leiten.

Gleichzeitig mit der Gate-Source-Kapazität des Leistungs-FET 1 wird auch der Kondensator 10 über die Kollektor-Emitter-Strecke des Bipolartransistors 8 aufgeladen. Wird nun in den Eingangsanschluß 11 eine Impulsfolge eingespeist, so wird das Potential am Verbindungspunkt zwischen Kondensator 10 und Diode 9 angehoben und die Gate-Source-Kapazität des Leistungs-FET wird weiter aufgeladen. Eine Entladung des Kondensators 10 über den Widerstand 14 und die Last 2 nach Masse wird über die in Sperrichtung vorgespannte Basis-Emitter-Strecke des Bipolartransistors 8 verhindert. Die Basis-Emitterstrecke des Bipolartransistors entspricht der zweiten Diode der bekannten Schaltung. Selbstverständlich kann auch in der Schaltung nach Figur 1 statt des Bipolartransistors 8 zur Vereinfachung eine einfache Diode verwendet werden, deren Anodenanschluß mit dem Drain-Anschluß des FET 5 und deren Katodenanschluß mit den Anodenanschlüssen der ersten Diode 9 verbunden ist.

Zum Abschalten des Leistungs-FET 1 wird der steuerbare Schalter 12 geöffnet. Damit steigt die Spannung am Gate-Anschluß des Depletion-FET 16 und dieser wird leitend gesteuert. Der FET 5 und der Bipolartransistor 8 werden gleichzeitig gesperrt. Damit wird die Gate-Source-Kapazität des Leistungs-FET 1 entladen und der Transistor sperrt. Die Widerstände 17, 18 und 19 sind derart dimensioniert, daß der größte Teil des weiterhin in den ersten Eingang gespeisten Stroms durch den Depletion-FET 16 abfließt, so daß ein erneutes Aufladen der Gate-Source-Kapazität des Leistungs-FET 1 unterbleibt.

Den Widerständen 6, 14 können Zener-Dioden 7, 14 parallel geschaltet werden. Die Zener-Diode 7 schützt die Gate-Source-Kapazität des FET 5 gegen Überspannung. Durch die Zener-Diode 15 wird verhindert, daß der Bipolartransistor 8 übersteuert wird.

Die beschriebenen Schaltung hat den Vorteil, daß sie den Leistungs-FET 1 im Fall eines Kurzschlusses der Last 2 schützt. In diesem Fall liegt der Anschluß 4 auf Massepotential und das Basispotential des Bipolartransistors 8 wird auf die Zenerspannung der Zenerdiode 15 begrenzt. Am Gateanschluß des Leistungs-FET 1 liegt dann maximal die erwähnte Zenerspannung abzüglich der Durchlaßspannungen der Basis-Emitterdiode des Bipolartransistors 8 und der Diode 9 an. Durch Auswahl der Zenerdiode 15 läßt sich somit die maximale Gate-Sourcespannung des Leistungs-FET 1 und damit der maximale Strom im Kurzschlußfalls einstellen.

Die Schaltungsanordnung nach Figur 2 unterscheidet sich von der nach Figur 1 durch eine Reihe von Weiterbildungen, die jeweils für sich oder in beliebiger Kombination angewandt werden können. Gleiche oder funktionsgleiche Elemente wie in Figur 1 sind mit gleichen Bezugszeichen versehen.

Gemäß einer ersten Weiterbildung kann zwischen dem Drain-Anschluß des Leistungs-FET und dem Verbindungspunkt zwischen den Widerständen 17 und 19 eine Anti-Serien-Schaltung aus einer Zener-Diode 25 und einer Diode 26 angeschlossen sein . Hierbei ist die Katode der Zenerdiode mit dem Drainanschluß von 1 verbunden. Dadurch werden Spannungsspitzen abgebaut, die beim Abschalten einer induktiven Last auftreten können.

Gemäß einer zweiten Weiterbildung können zwischen dem Verbindungspunkt der Widerstände 17 und 19 und dem Source-Anschluß des Leistungs-FET 1 Mittel 27 zur Spannungsbegrenzung vorgesehen sein. Diese werden von der Drain-Spannung des Leistungs-FET 1 über eine Steuerleitung 28 derart gesteuert, daß bei Anwachsen der Drain-Source-Spannung z.B. infolge eines Kurzschlusses die Gate-Source-Spannung des Leistungs-FET verringert wird. Damit läßt sich eine Strombegrenzung im Leistungs-FET erreichen.

Eine weitere Verbesserung kann darin bestehen, daß zwischen die erste Diode 9 und den Widerstand 17 eine dritte Diode 21 eingeschaltet wird. Dabei ist die Anode von 21 mit der Katode von 9 verbunden. Der Verbindungspunkt beider Dioden ist über einen weiteren Kondensator 23 mit einem dritten Eingangsanschluß 24 verbunden.

Wird an den Anschluß 24 eine Impulsfolge angelegt, die gegenüber der an den Eingang 11 angelegten Impulsfolge um 180° phasenverschoben ist, so addiert sich die am Katodenanschluß der Diode 9 hochgepumpte Spannung zur Spannung des Kondensators 23. Damit wird ein schnelleres Ansteigen der Gatespannung des Leistungs-FET 1 erreicht.

Die Entladung des Kondensators 23 in den Ladepausen wird über die Basis-Emitterstrecke eines Bipolartransistors 22 verhindert, dessen Emitter zwischen Katode der Diode 9 und Anode der Diode 21 angeschlossen ist. Sein Kollektor- und Basisanschluß ist mit dem Kollektor- bzw. Basisanschluß des Bipolartransistors 8 verbunden. Der Bipolartransistor 22 wird gleichzeitig mit dem Bipolartransistor 8 über den FET 5 eingeschaltet. Über die Kollektor-Emitterstrecker des Bipolartransistors 22, die Diode 21 und die Widerstände 17 und 19 wird die Gate-Source-Kapazität des Leistungs-FET 1 zusätzlich aufgeladen.

Der steuerbare Schalter 12 wurde in den Figuren als mechanischer Schalter dargestellt. Zweckmäßigerweise ist er ein elektronischer Schalter, z.B. ein FET.

## Patentansprüche

1. Schaltungsanordnung zum Ansteuern eines Leistungs-FET, dem sourceseitig eine Last in Reihe geschaltet ist, mit den Merkmalen:
a) Die Gateelektrode des Leistungs-FET (1) ist über eine erste Diode (9) und einen Kondensator (10) mit einem ersten Eingangsanschluß (11) verbunden,
b) zwischen erster Diode und Kondensator ist eine zweite Diode angeschlossen, die über die Drain-Sourcestrecke eines zweiten FET (5) mit dem Drainanschluß des Leistungs-FET (1) verbunden ist,
c) der zweite FET ist vom dem Leistungs-FET entgegengesetzten Kanaltyp,
d) zwischen Gate- und Sourceanschluß des zweiten FET (5) ist ein Widerstand (6) angeschlossen,
e) der Gateanschluß des zweiten FET ist mit einem steuerbaren Schalter (12) verbunden,
f) die Gate-Sourcekapazität des Leistungs-FET ist über die Drain-Sourcestrecke eines dritten FET (16) entladbar,
**gekennzeichnet durch** die Merkmale:
g) der dritte FET (16) ist ein Depletion-FET,
h) der Gateanschluß des Depletion-FET (16) ist mit dem steuerbaren Schalter (12) verbunden,
i) die Drain-Sourcestrecke des Depletion-FET ist zwischen den Gateanschluß und den Sourceanschluß des Leistungs-FET (1) geschaltet,
k) der steuerbare Schalter (12) ist mit einem zweiten Eingangsanschluß (13) verbunden.
l) an den zweiten Eingangsanschluß (13) wird eine Sapnnung angelegt, die kleiner als die Versorgungsspannung ist.

2. Schaltungsanordnung nach Anspruch 1,
**dadurch gekennzeichnet,** daß dem Widerstand (6) eine Zenerdiode (7) parallel geschaltet ist.

3. Schaltungsanordnung nach Anspruch 1 oder 2,
**dadurch gekennzeichnet**, daß die zweite Diode durch die Basis-Emitterstrecke eines Bipolartransistors (8) gebildet ist, daß der Basisanschluß des Bipolartransistors mit dem Drainanschluß des zweiten FET (5) und über einen Widerstand (14) mit dem Sourceanschluß des Leistungs-FET (1) verbunden ist, daß sein Emitteranschluß mit der ersten Diode verbunden ist und der Kollektoranschluß mit dem Sourceanschluß des zweiten FET (5).

4. Schaltungsanordnung nach Anspruch 3,
**dadurch gekennzeichnet**, daß dem Widerstand (14) eine Zenerdiode (15) parallel geschaltet ist.

5. Schaltungsanordnung nach einem der Ansprüche 1 bis 4,
**gekennzeichnet durch** die Merkmale:
a) Zwischen der ersten Diode (9) und dem Gateanschluß des Leistungs-FET (1) ist eine dritte Diode (21) eingeschaltet,
b) mit dem Knoten zwischen erster und dritter Diode ist der Emitteranschluß eines zweiten Bipolartransistors (22) verbunden,
c) der Basis- und Kollektoranschuß des zweiten Bipolartransistors (22) ist mit dem Drain- bzw. Sourceanschluß des zweiten FET (5) verbunden,
d) der Emitteranschluß des zweiten Bipolartransistors (22) ist über einen zweiten Kondensator (23) mit einem dritten Eingangsanschluß (24) verbunden,
e) an die ersten und dritten Eingangsanschlüsse werden zueinander Eingangssignale angelegt, die gegeneinander um 180° phasenverschoben sind.

6. Schaltungsanordnung nach einem der Ansprüche 1 bis 5,
**dadurch gekennzeichnet**, daß zwischen dem Gateanschluß und dem Drainanschluß des Leistungs-FET (1) die Antiserienschaltung aus einer Diode (26) und einer Zenerdiode (25) angeschlossen ist.

7. Schaltungsanordnung nach einem der Ansprüche 1 bis 6,
**dadurch gekennzeichnet**, daß zwischen dem Gateanschluß und dem Sourceanschluß des Leistungs-FET (1) Mittel (27) vorgesehen sind, die die Gate-Sourcespannung des Leistungs-FET in Abhängigkeit von der Drainspannung des Leistungs-FET begrenzen.

8. Schaltungsanordnung nach Anspruch 1,
**dadurch gekennzeichnet**, daß der steuerbare Schalter ein FET ist.

## Claims

1. Circuit arrangement for driving a power FET, a load being connected in series with the source side of said power FET, having the features:
a) the gate electrode of the power FET (1) is connected to a first input terminal (11) via a first diode (9) and a capacitor (10),
b) a second diode is connected between the first diode and the capacitor and is connected to the drain terminal of the power FET (1) via the drain-source path of a second FET (5),
c) the second FET is of the opposite channel type to the power FET,
d) a resistor (6) is connected between the gate and source terminals of the second FET (5),
e) the gate terminal of the second FET is connected to a controllable switch (12),
f) the gate-source capacitance of the power FET can be discharged via the drain-source path of a third FET (16),
characterized by the features:
g) the third FET (16) is a depletion-mode FET,
h) the gate terminal of the depletion-mode FET (16) is connected to the controllable switch (12),
i) the drain-source path of the depletion-mode FET is connected between the gate terminal and the source terminal of the power FET (1),
k) the controllable switch (12) is connected to a second input terminal (13),
l) a voltage which is less than the supply voltage is applied to the second input terminal (13).

2. Circuit arrangement according to Claim 1, characterized in that a zener diode (7) is connected in parallel with the resistor (6).

3. Circuit arrangement according to Claim 1 or 2, characterized in that the second diode is formed by the base-emitter junction of a bipolar transistor (8), in that the base terminal of the bipolar transistor is connected to the drain terminal of the second FET (5) and, via a resistor (14), to the source terminal of the power FET (1), in that its emitter terminal is connected to the first diode and the collector terminal is connected to the source terminal of the second FET (5).

4. Circuit arrangement according to Claim 3, characterized in that a zener diode (15) is connected in parallel with the resistor (14).

5. Circuit arrangement according to one of Claims 1 to 4, characterized by the features:
a) a third diode (21) is connected in between the first diode (9) and the gate terminal of the power FET (1),
b) the emitter terminal of a second bipolar transistor (22) is connected to the node between the first and third diodes,
c) the base and collector terminals of the second bipolar transistor (22) are connected to the drain and source terminals, respectively, of the second FET (5),
d) the emitter terminal of the second bipolar transistor (22) is connected to a third input terminal (24) via a second capacitor (23),
e) input signals which are phase shifted through 180° relative to one another are mutually applied to the first and third input terminals.

6. Circuit arrangement according to one of Claims 1 to 5, characterized in that the reverse-connected series circuit formed by a diode (26) and a zener diode (25) is connected between the gate terminal and the drain terminal of the power FET (1).

7. Circuit arrangement according to one of Claims 1 to 6, characterized in that means (27) which limit the gate-source voltage of the power FET as a function of the drain voltage of the power FET are provided between the gate terminal and the source terminal of the power FET (1).

8. Circuit arrangement according to Claim 1, characterized in that the controllable switch is a FET.

## Revendications

1. Montage pour commander un transistor de puissance à effet de champ avec lequel une charge est branchée en série du côté de la source et qui a les dispositions:
a) l'électrode de grille du transistor (1) de puissance à effet de champ est reliée à une première borne (11) d'entrée par l'intermédiaire d'une première diode (9) et d'un condensateur (10),
b) il est raccordé entre la première diode et le condensateur une deuxième diode, qui est reliée à la borne de drain du transistor (1) de puissance à effet de champ par l'intermédiaire de la section drain-source d'un deuxième transistor (5) à effet de champ,
c) le deuxième transistor à effet de champ est à canal de type opposé à celui du transistor de puissance à effet de champ,
d) une résistance (6) est raccordée entre la borne de grille et la borne de source du deuxième (5) transistor à effet de champ,
e) la borne de grille du deuxième transistor à effet de champ est relié à un interrupteur (12) qui peut être commandé,
f) la capacité grille-source du transistor de puissance à effet de champ peut être déchargée par l'intermédiaire de la section drain-source d'un troisième transistor (16) à effet de champ,
caractérisé par les dispositions:
g) le troisième transistor (16) à effet de champ est un transistor à effet de champ à déplétion,
h) la borne de grille du transistor (16) à effet de champ à déplétion est reliée à l'interrupteur (12) pouvant être commandé,
i) la section drain-source du transistor à effet de champ à déplétion est branchée entre la borne de grille et la borne de source du transistor (1) de puissance à effet de champ,
k) l'interrupteur (12) qui peut être commandé est relié à une deuxième borne (13) d'entrée,
I) il est appliqué à la deuxième borne (13) d'entrée une tension qui est inférieure à la tension d'alimentation.

2. Montage suivant la revendication 1, caractérisé en ce qu'une diode (7) de Zener est branchée en parallèle à la résistance (6).

3. Montage suivant la revendication 1 ou 2, caractérisé en ce qua deuxième diode est formée par la section base-émetteur d'un transistor (8) bipolaire, en ce que la borne de base du transistor bipolaire est reliée à la borne de drain du deuxième transistor (5) à effet de champ et, par l'intermédiaire d'une résistance (14), à la borne de source du transistor (1) de puissance à effet de champ, en ce que sa borne d'émetteur est reliée à la première diode et la borne de collecteur à la borne de source du deuxième transistor (5) à effet de champ.

4. Montage suivant la revendication 3, caractérisé en ce qu'une diode (15) de Zener est branchée en parallèle à la résistance (14).

5. Montage suivant l'une des revendications 1 à 4, caractérisé par les dispositions:
a) une troisième diode (21) est branchée entre la première diode (9) et la borne de grille du transistor (1) de puissance à effet de champ,
b)la borne d'émetteur d'un deuxième transistor (22) bipolaire est reliée au point de liaison entre la première et la troisième diode,
c) la borne de base et la borne de collecteur du deuxième transistor (22) bipolaire sont reliées respectivement à la borne de drain et à la borne de source du deuxième transistor (5) à effet de champ,
d) la borne d'émetteur du deuxième transistor (22) bipolaire est reliée à une troisième borne (24) d'entrée par l'intermédiaire d'un autre condensateur (23),
e) il est appliqué aux premières et troisièmes bornes d'entrée des signaux d'entrée qui sont déphasés les uns par rapport aux autres de 180°.

6. Montage suivant l'une des revendications 1 à 5, caractérisé en ce qu'il est raccordé entre la borne de grille et la borne de drain du transistor (1) de puissance à effet de champ le circuit-série inversé, constitué d'une diode (26) et d'une diode (25) de Zener.

7. Montage suivant l'une des revendications 1 à 6, caractérisé en ce qu'il est prévu entre la borne de grille et la borne de source du transistor (1) de puissance à effet de champ, des moyens (27) qui limitent la tension grille-source du transistor de puissance à effet de champ en fonction de la tension de drain du transistor de puissance à effet de champ.

8. Montage suivant la revendication 1, caractérisé en ce que l'interrupteur qui peut être commandé est un transistor à effet de champ.
